# EUROPÄISCHE PATENTSCHRIFT

(11) **EP 2 704 326 B1**
(45) Veröffentlichungstag und Bekanntmachung des Hinweises auf die Patenterteilung: **23.05.2018**
(21) Anmeldenummer: 12182167.2
(22) Anmeldetag: 29.08.2012
(51) Int. Cl.: H03K 17/16, H03K 17/12

(54) **Ausgabebaugruppe und Verfahren zum Betrieb**
Output module and method for operation
Composant de sortie et son procédé de fonctionnement

(43) Veröffentlichungstag der Anmeldung: 05.03.2014
(73) Patentinhaber: Siemens Aktiengesellschaft, 80333 München (DE)
(72) Erfinder: Haritounian, Sevan, 92224 Amberg (DE); Deml, Michael, 92436 Bruck (DE); Fichtlscherer, Martin, 92280 Kastl (DE); Kemptner, Sebastian, 92521 Schwarzenfeld (DE); Kiendl, Thomas, 92533 Wernberg-Köblitz (DE); König, Mathias, 91284 Neuhaus an der Pegnitz (DE); Mark, Reinhard, 91217 Hersbruck (DE); Vogel, René, 91217 Hersbruck (DE)

(56) Entgegenhaltungen:
- WO-A1-2011/096232
- US-A1- 2003 038 615
- US-A1- 2010 308 872

## Beschreibung

Die Erfindung betrifft ein Verfahren zum Betrieb einer Ausgabebaugruppe mit einer Ausgangsschaltung mit der an eine an einen Ausgang angeschlossene Last eine Spannung angeschaltet wird, welche einen Strom I zur Folge hat, wobei zwischen einem Versorgungsspannungsanschluss der Ausgabebaugruppe und dem Ausgang ein erstes Treibermodul betrieben wird und zur Spannungsanschaltung an den Ausgang über einen ersten Steuereingang angesteuert wird.
Für das Schalten, von beispielsweise kapazitiven Lasten, mit einer, vorzugsweise fehlersicheren, digitalen, Ausgabebaugruppe einer speicherprogrammierbaren Steuerung, werden bereits heute elektronische Leistungsbauelemente zum Schalten der positiven Ausgangsspannung in einer Ausgabebaugruppe eingesetzt.

Insbesondere beim Einschalten von kapazitiven Lasten mit geringem Serienwiderstand tritt im ersten Augenblick ein hoher Einschaltstrom auf. Bei Leistungsbauelementen, die über eine Abschaltung in einem Kurzschlussfall verfügen, kann dieser hohe Strom zu einem Ansprechen einer Überstromüberwachung oder Kurzschlussstromüberwachung und damit zu einer Abschaltung des Leistungsbauelementes führen.
Die Offenlegungsschrift DE 10 2006 030 448 A1 offenbart eine Ausgangsschaltung für eine Ausgangsbaugruppe zum Schalten wenigstens einer angeschlossenen Last.
Die Veröffentlichung US 2012/10307540 A1 zeigt einen Spannungsconverter, insbesondere einen Wechselrichter, bei welchen zur Erhöhung der Lebensdauer Leistungsverluste und Schaltverluste in den Halbleiterschaltern minimiert werden.

Die Veröffentlichung US 2010/308872 A1 offenbart eine Ausgabebaugruppe für eine speicherprogrammierbare Steuerung mit einer Ausgangsschaltung, die die Aktivität der parallelen Treibermodule in Abhängigkeit von dem Strom in dem Treibermodul steuert. Da eine Baugröße von Ausgabebaugruppen, insbesondere in der Automatisierungstechnik, sich stetig verkleinert, wird nach einer Lösung gesucht um bei einem reduzierten Bauraum der Ausgabebaugruppe und einer zusätzlich erhöhten Packungsdichte von elektronischen Bauelementen auf einer Leiterplatte der Ausgabebaugruppe eine Erwärmung auf zulässige Werte zu begrenzen oder auch die Verlustleistung möglichst gering zu halten.

Es ist demnach Aufgabe der Erfindung eine Ausgabebaugruppe bereitzustellen, welche es ermöglicht, insbesondere beim Schalten von kapazitiven Lasten, den zu Anfang eines Schaltvorganges herrschenden hohen Einschaltstrom zu bewältigen und dennoch die Ausgabebaugruppe nicht zu sehr mit entstehender Verlustwärme zu belasten.

Bei einem Verfahren zum Betrieb einer digitalen Ausgabebaugruppe für eine speicherprogrammierbare Steuerung mit einer Ausgangsschaltung mit der an eine an einen Ausgang angeschlossene Last eine Spannung angeschaltet wird, welche einen Strom zur Folge hat, wobei zwischen einem Versorgungsspannungsanschluss der Ausgabebaugruppe und dem Ausgang ein erstes Treibermodul betrieben wird und zur Spannungsanschaltung an den Ausgang über einen ersten Steuereingang angesteuert wird, wird die Aufgabe dadurch gelöst, dass zwischen dem Versorgungsspannungsanschluss und dem Ausgang ein zweites Treibermodul parallel zu dem ersten Treibermodul betrieben wird und auch zur Stromanschaltung an den Ausgang über einen zweiten Steuereingang angesteuert wird, wobei eine Steuerschaltung einen Schaltbefehl zum Schalten der Spannung an den Ausgang zu einem Startzeitpunkt erhält und die Steuerschaltung daraufhin den zweiten Steuereingang für eine vorbestimmte erste Zeitdauer ansteuert, dabei wird das zweite Treibermodul mit einer Strombegrenzung für einen maximalen Strom betrieben und ausgehend von dem Startzeitpunkt nach Ablauf einer vorbestimmten zweiten Zeitdauer wird die Steuerschaltung daraufhin den ersten Steuereingang solange ansteuern, wie der Schaltbefehl gültig ist, wobei in dem ersten Treibermodul eine Stromabschaltvorrichtung derart betrieben wird, das diese nur noch auslöst, wenn ein Kurzschluss auftritt. Die Ausgabebaugruppe wird somit über zwei Arten von Treibermodulen bzw. elektronischen Leistungsbauelementen betrieben, beispielsweise einem Haupttreiber-Baustein zum Schalten durch einen Schaltbefehl von einem Anwenderprogramm in einer speicherprogrammierbaren Steuerung und einem Nebentreiber-Baustein auch zum Schalten der kapazitiven Last, aber mit der Hauptaufgabe den zu Beginn eines Schaltvorganges herrschenden hohen Einschaltstrom zu bewältigen. Hierzu ist dieser Nebentreiber-Baustein, nämlich das zweite Treibermodul mit einer Strombegrenzungsvorrichtung ausgestaltet und wird derart betrieben, dass eine Strombegrenzung für einen maximalen Strom zumindest für eine erste Zeitdauer T1 durchgeführt wird. Durch das Anschalten der, vorzugsweise kapazitiven Last, durch das zweite Treibermodul für beispielsweise eine Zeitdauer von nur einigen Millisekunden unter Zuhilfenahme der Strombegrenzung, wird die Last bereits zugeschaltet und bei einer möglichen kapazitiven Last dadurch ein annähernd vollständiges Aufladen der Kapazität gewährleistet. Danach wird das erste Treibermodul angesteuert, also sozusagen der Haupttreiber wird eingeschaltet und die entstehenden Verlustleistungen können sich auf das erste Treibermodul und das zweite Treibermodul verteilen.

Vorzugsweise wird bei dem Verfahren die zweite Zeitdauer kleiner als die erste Zeitdauer oder gleich der ersten Zeitdauer gewählt. Der Strom und damit die Verlustleistung werden dadurch noch eine zeitlang auf zwei Treibermodule bzw. Halbleiterschaltelemente aufgeteilt und eine Wärmeentwicklung in der Ausgabebaugruppe kann besser abgeführt werden.

Die Verlustleistung und die damit gleichzeitig auftretenden Temperaturen im eingeschalteten Zustand können bei Dauerbetrieb gering gehalten werden und trotzdem kapazitive Lasten eingeschaltet werden, da das erste Treibermodul einen kleineren Schaltwiderstand aufweist als das zweite Treibermodul. Der Schaltwiderstand des zweiten Treibermoduls ist größer, weil dieses mit einer Strombegrenzungsvorrichtung ausgestaltet ist.

Vorteilhafter Weise findet das Verfahren Anwendung bei Ausgabebaugruppen, die als eine fehlersichere und auf funktionale Sicherheit ausgelegte Automatisierungskomponente darstellen.

In Bezug auf die Sicherheit wird das zweite Treibermodul mit einem Drahtbruchprüfmittel betrieben und zyklisch für eine Drahtbruchprüfung einer zu der Last geführten Leitung aktiviert, wobei während dieser Prüf-Zeit das erste Treibermodul ausgeschaltet wird. Die Zeitdauer einer Prüfzeit und damit die Ausschaltung des ersten Treibermoduls ist derart kurz, dass dies auf die Funktionstüchtigkeit der angesteuerten Last keine Auswirkung hat.

Das eingangs genannte Problem des Einschaltens von kapazitiven Lasten wird demnach dadurch gelöst, in dem man ein Treibermodul als einen Drahtbruchtreiber mit einer Strombegrenzung und damit einem relativ großen Einschaltwiderstand, also einer entsprechend hohen Verlustleistung einsetzt, und als Haupttreiber ein Treibermodul ohne eine Strombegrenzung, welches einen relativ geringen Schaltwiderstand aufweist.

Die eingangs genannte Aufgabe wird ebenso durch eine Ausgabebaugruppe, umfassend eine Ausgangsschaltung, einen Ausgang, einen Versorgungsspannungsanschluss, ein erstes Treibermodul mit einem ersten Steuereingang, wobei das erste Treibermodul zur Anschaltung einer Spannung an den Ausgang ausgestaltet ist und zwischen dem Versorgungsspannungsanschluss und dem Ausgang angeordnet ist, dadurch gelöst, dass zwischen dem Versorgungsspannungsanschluss und dem Ausgang ein zweites Treibermodul mit einem zweiten Steuereingang parallel zu dem ersten Treibermodul angeordnet ist und auch zur Spannungsanschaltung an den Ausgang ausgestaltet ist, wobei eine Steuerschaltung einen Befehlseingang, einen ersten Befehlsausgang und einen zweiten Befehlsausgang aufweist und ausgestaltet ist, um einen Schaltbefehl zum Schalten der Spannung an den Ausgang zu einem Startzeitpunkt über den Befehlseingang entgegenzunehmen und daraufhin den zweiten Steuereingang für eine vorbestimmte erste Zeitdauer anzusteuern, wobei das zweite Treibermodul mit einer Strombegrenzungsvorrichtung für einen maximalen Strom ausgestaltet ist und die Steuerschaltung weiterhin dazu ausgestaltet ist, ausgehend von dem Startzeitpunkt nach Ablauf einer vorbestimmten zweiten Zeitdauer den ersten Steuereingang solange anzusteuern, wie der Schaltbefehl gültig ist, wobei das erste Treibermodul mit einer Stromabschaltvorrichtung ausgestaltet ist.

Da vorzugsweise nach dem Erreichen dieses annähernden Ladezustandes das zweite Treibermodul wieder ausgeschaltet wird und nun das erste Treibermodul den Strom für die zu schaltende Last führt, weist bei der Ausgabebaugruppe das erste Treibermodul eine Stromabschaltvorrichtung auf, welche von nun an nur noch zum Tragen kommt, wenn beispielsweise ein Fehler, wie ein Kurzschluss auftritt.

Um einen hohen Einschaltstrom, insbesondere beim Schalten von kapazitiven Lasten, zu bewältigen ist das zweite Treibermodul mit einer Strombegrenzungsvorrichtung ausgestaltet, welches nur einen maximalen Strom zulässt und damit auch nur eine maximale Verlustleistung und somit auch nur eine maximale Erwärmung hervorruft. Dieses zweite Treibermodul wird über den zweiten Steuereingang, vorzugsweise nur solange angesteuert, bis eine Kapazität einer kapazitiven Last annähernd aufgeladen ist und ein Strom bei einem weiteren Ladevorgang unter den Wert eines maximalen zulässigen Stromes wieder fallen würde.

Insbesondere bei einem Einsatz von fehlersicheren Ausgabebaugruppen in der Automatisierungstechnik weist das zweite Treibermodul zusätzlich ein Drahtbruchprüfmittel auf, welches für eine zyklische Drahtbruchprüfung einer zu der Last geführten Leitung ausgestaltet ist.

Die Zeichnung zeigt ein Ausführungsbeispiel, dabei zeigt:
- FIG 1: eine Ausgabebaugruppe 1 mit einem ersten Treibermodul 11 und einem zweiten Treibermodul 12,
- FIG 2: zeitliche Verläufe der Ansteuerung der Treibermodule, sowie eine Ausgangsspannung an dem Ausgang und
- FIG 3: ein Spannungs-Stromdiagramm bezogen auf die zu schaltende Last.

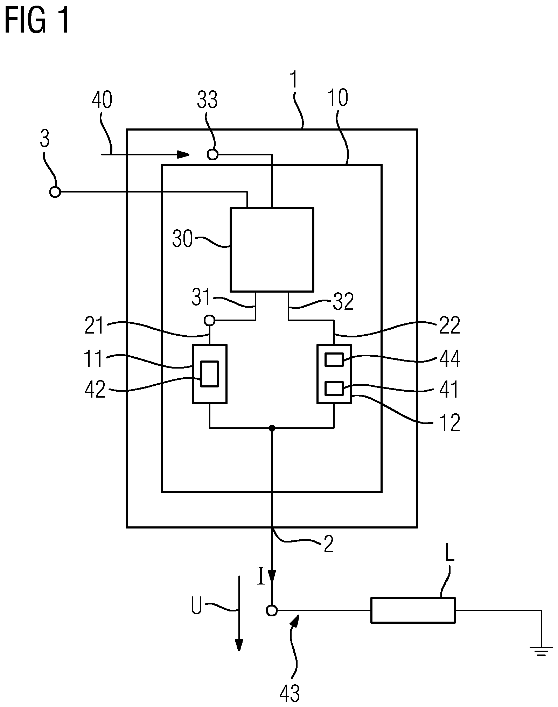

Gemäß FIG 1 ist eine Ausgabebaugruppe 1, umfassend eine Ausgangsschaltung 10, einen Ausgang 2, einen Versorgungsspannungsanschluss 3, ein erstes Treibermodul 11 mit einem ersten Steuereingang 21 und ein zweites Treibermodul 12 mit einem zweiten Steuereingang 22 gezeigt. Die Ausgabebaugruppe 1 ist mit ihrer Ausgangsschaltung 10 dazu ausgestaltet, eine Spannung U über einen Ausgang 2 an eine Last L zu schalten, welches einen Strom I zur Folge hat.

Um eine entstehende Verlustleistung in der Ausgangsschaltung 10 in Grenzen zu halten wird vorgeschlagen zwei Halbleiterschaltelemente, nämlich das erste Treibermodul 11 und das zweite Treibermodul 12 derart einzusetzen, dass diese sequenziell nacheinander geschaltet werden. Dazu sieht das Verfahren für den Betrieb der Ausgabebaugruppe vor, dass zwischen dem Versorgungsspannungsanschluss 3 und dem Ausgang 2 das zweite Treibermodul 12 parallel zu dem ersten Treibermodul 11 betrieben wird und beide Treibermodule 11,12 dazu ausgestaltet sind eine Spannungsanschaltung an den Ausgang 2 zu realisieren. Bekommt das erste Treibermodul 11 über einen ersten Steuereingang 21 einen Einschaltbefehl, so schaltet es die Spannung U an den Ausgang 2, welches einen Strom I auf die Last L aufprägt. Bekommt das zweite Treibermodul 12 über einen zweiten Steuereingang 22 auch einen Einschaltbefehl, so prägt das zweite Treibermodul 12 ebenso einen Strom I auf die zu schaltenden Last L auf.

Die Ausgabebaugruppe 1 ist vorzugsweise in einem Automatisierungsumfeld mit einer speicherprogrammierbaren Steuerung eingesetzt. Zum Aktivieren der Ausgabebaugruppe sendet die speicherprogrammierbare Steuerung, beispielsweise über ein Kommunikationsnetzwerk, einen Schaltbefehl 40 ab. Dieser Schaltbefehl 40 wird über einen Befehlseingang 33 der Steuerschaltung 30 entgegengenommen und damit ein Schaltvorgang der kapazitiven Last L über die Treibermodule 11,12 gestartet.

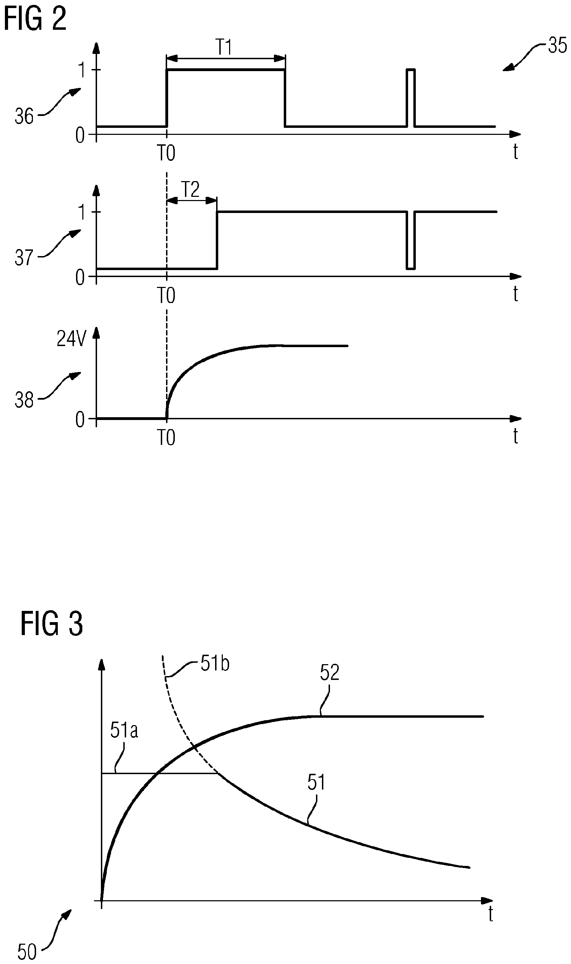

Die Steuerschaltung 30 ist dabei derart ausgestaltet, dass wenn die Steuerschaltung 30 den Schaltbefehl 40 zum Schalten der Spannung U an den Ausgang 2 zu einem Startzeitpunkt T0 erhält, zunächst der zweite Steuereingang 22 über ihren zweiten Befehlsausgang 32 für eine vorbestimmte erste Zeitdauer T1 angesteuert wird. Da das zweite Treibermodul 22 mit einer Strombegrenzungsvorrichtung 41 ausgestaltet ist, kann der Strom I einen maximal zulässigen Strom I nicht überschreiten (siehe FIG 3).
Weiterhin ist die Steuerschaltung 30 derart ausgestaltet, dass ausgehend von dem Startzeitpunkt T0 nach Ablauf einer vorbestimmten zweiten Zeitdauer T2 die Steuerschaltung 30 daraufhin zusätzlich den ersten Steuereingang 21 über einen ersten Befehlsausgang 31 solange ansteuert, wie der Schaltbefehl 40 gültig ist.

Die vorbestimmten Zeiten, also die erste Zeitdauer T1 und die zweite Zeitdauer T2 sind dabei in der Steuerschaltung 30 derart implementiert, dass die zweite Zeitdauer T2 kleiner als die erste Zeitdauer T1 oder gleich der ersten Zeitdauer T1 gewählt ist.

Für einen Betrieb in der Automatisierungstechnik, insbesondere beim Einsatz von Ausgabebaugruppen als fehlersichere auf funktionale Sicherheit ausgelegte Automatisierungskomponenten, weist das zweite Treibermodul ein Drahtbruchprüfmittel 44 auf, welches derart ausgestaltet ist, dass das Drahtbruchprüfmittel 44 zyklisch für eine Drahtbruchprüfung einer zu der Last L geführten Leitung 43 aktiviert wird, wobei während dieser Prüf-Zeit das erste Treibermodul 11 kurzzeitig ausgeschaltet wird.

Mit der FIG 2 sind zeitliche Verläufe 35 der Ansteuerung der Treibermodule 11,12 und ein Spannungsverlauf 38 der Ausgangsspannung am Ausgang 2 dargestellt. Ein erstes Diagramm zeigt einen Signalverlauf 36 am zweiten Steuereingang 22 des zweiten Treibermoduls 12. Über die Zeit t ist ein logisches Schaltverhalten zwischen "0" und "1" dargestellt. Über die Steuerschaltung 30 wird zu einem Startzeitpunkt T0 der zweite Steuereingang 22 mit logisch "1" angesteuert. Diese Ansteuerung wird für eine erste Zeitdauer T1 durchgeführt. Unter dem Signalverlauf 36 am zweiten Steuereingang 22 ist ein logisches Schaltdiagramm für einen Signalverlauf 37 am ersten Steuereingang 11 abgebildet. Demnach bekommt der erste Steuereingang 21 des ersten Treibermoduls 11 mit einer Zeitverzögerung von einer zweiten Zeitdauer T2 nach dem Startzeitpunkt T0 erst seinen Einschaltbefehl von "0" nach "1".

Im weiteren zeitlichen Verlauf ist in den logischen Signalverläufen 36 und 37 die zyklische Drahtbruchprüfung angedeutet, dazu wird das zweite Treibermodul 22 kurzzeitig aktiviert und dementsprechend das erste Treibermodul 21 kurzzeitig deaktiviert. Sollte das in dem zweiten Treibermodul 22 enthaltene Drahtbruchprüfmittel 44 während dieser kurzzeitigen Aktivierung des Stromes keinen Stromfluss feststellen, so würde das Drahtbruchprüfmittel 44 einen Alarm ausgeben, welcher sagt, dass die Leitung 43 zu der Last L defekt sein muss. Damit das Drahtbruchprüfmittel 44 hier fehlerfrei Messen kann, muss der von dem ersten Treibermodul 11 aufgeprägte Strom I natürlich kurzzeitig unterbrochen sein.

In einem weiteren Spannungsdiagramm der FIG 2 ist die Ausgangsspannung 38 am Ausgang 2 der Ausgabebaugruppe 1 dargestellt. Zu dem Startzeitpunkt T0, bei welchem das zweite Treibermodul 22 aktiviert wird, steigt die Ausgangsspannung 38 an der Last L bzw. an dem Ausgang 2 allmählich an. Es ist eine typische Spannungskurve für das Ladeverhalten eines Kondensators zu erahnen.

Die FIG 3 zeigt ein Spannungs-Stromdiagramm 50 mit welchem die Strombegrenzung durch die Strombegrenzungsvorrichtung 41 in dem zweiten Treibermodul 12 gezeigt ist. Dabei zeigt eine Kurve den zeitlichen Verlauf 51 des Stromes I, wobei insbesondere kurz nach einem Einschaltzeitpunkt sich der Verlauf des Stromes I in einen zeitlichen Verlauf 51a mit einer Strombegrenzung und in einen zeitlichen Verlauf 51b ohne eine Strombegrenzung teilt. Bei einem Schalten einer kapazitiven Last L würde ohne eine Strombegrenzung der Fall des zeitlichen Verlaufes 51b des Stromes I auftreten und damit würden unzulässig hohe Stromwerte in der Ausgabebaugruppe 1 auftreten. Zur Verdeutlichung ist der zeitliche Verlauf 51b des Stromes ohne Begrenzung gestrichelt gezeichnet.

Da in dem zweiten Treibermodul 12 die Strombegrenzungsvorrichtung 51 implementiert ist, wird bei Betrieb der Ausgabebaugruppe 1 der zeitliche Verlauf 51a des Stromes mit Begrenzung erreicht.

Die Kurve 52 zeigt den zeitlichen Verlauf der Spannung.

## Patentansprüche

1. Verfahren zum Betrieb einer digitalen Ausgabebaugruppe (1) für eine speicherprogrammierbare Steuerung mit einer Ausgangsschaltung (10) mit der an eine an einen Ausgang (2) angeschlossene Last (L) eine Spannung (U) angeschaltet wird, welche einen Strom (I) zur Folge hat, wobei zwischen einem Versorgungsspannungsanschluss (3) der Ausgabebaugruppe (1) und dem Ausgang (2) ein erstes Treibermodul (11) betrieben wird und zur Spannungsanschaltung an den Ausgang (2) über einen ersten Steuereingang (21) angesteuert wird, wobei zwischen dem Versorgungsspannungsanschluss (3) und dem Ausgang (2) ein zweites Treibermodul (12) parallel zu dem ersten Treibermodul (11) betrieben wird und auch zur Spannungsanschaltung an den Ausgang (2) über einen zweiten Steuereingang (22) angesteuert wird, **dadurch gekennzeichnet, dass** eine Steuerschaltung (30) einen Schaltbefehl (40) zum Schalten der Spannung (U) an den Ausgang (2) zu einem Startzeitpunkt (T0) erhält und die Steuerschaltung (30) daraufhin zunächst den zweiten Steuereingang (22) für eine vorbestimmte erste Zeitdauer (T1) ansteuert, dabei wird das zweite Treibermodul (12) mit einer Strombegrenzung für einen maximalen Strom (I) betrieben und ausgehend von dem Startzeitpunkt (T0) nach Ablauf einer vorbestimmten zweiten Zeitdauer (T2) die Steuerschaltung (30) daraufhin zusätzlich den ersten Steuereingang (21) solange ansteuert, wie der Schaltbefehl (40) gültig ist wobei in dem ersten Treibermodul (11) eine Stromabschaltvorrichtung derart betrieben wird, das diese nur noch auslöst, wenn ein Kurzschluss auftritt.

2. Verfahren nach Anspruch 1, wobei die zweite Zeitdauer (T2) kleiner als die erste Zeitdauer (T1) oder gleich der ersten Zeitdauer (T1) gewählt wird.

3. Verfahren nach Anspruch 1 oder 2, wobei das erste Treibermodul (11) mit einer Stromabschaltvorrichtung (42) zur Unterbrechung des Stromes (I) bei Erreichen eines maximal zulässigen Stromes (I) betrieben wird.

4. Verfahren nach einem der Ansprüche 1 bis 3, wobei als eine angeschlossene Last (L) eine kapazitive Last geschaltet wird.

5. Verfahren nach einem der Ansprüche 1 bis 4, wobei die Ausgabebaugruppe (1) als eine fehlersichere auf funktionale Sicherheit ausgelegte Automatisierungskomponente betrieben wird.

6. Verfahren nach einem der Ansprüche 1 bis 5, wobei das zweite Treibermodul (12) mit einem Drahtbruchprüfmittel (44) betrieben wird und zyklisch für eine Drahtbruchprüfung einer zu der Last (L) geführten Leitung (43) aktiviert wird, wobei während dieser Prüf-Zeit das erste Treibermodul (11) ausgeschaltet wird.

7. Digitale Ausgabebaugruppe (1) für eine speicherprogrammierbare Steuerung, umfassend eine Ausgangsschaltung (10), einen Ausgang (2), einen Versorgungsspannungsanschluss (3) ein erstes Treibermodul (11) mit einem ersten Steuereingang (21), wobei das erste Treibermodul (11) zur Anschaltung einer Spannung (U) an den Ausgang (2) ausgestaltet ist und zwischen dem Versorgungsspannungsanschluss (3) und dem Ausgang (2) angeordnet ist, wobei zwischen dem Versorgungsspannungsanschluss (3) und dem Ausgang (2) ein zweites Treibermodul (12) mit einem zweiten Steuereingang (21) parallel zu dem ersten Treibermodul (11) angeordnet ist und auch zur Spannungsanschaltung an den Ausgang (2) ausgestaltet ist, **dadurch gekennzeichnet, dass** eine Steuerschaltung (30) einen Befehlseingang (33), einen ersten Befehlsausgang (31) und einen zweiten Befehlsausgang (32) aufweist und ausgestaltet ist um einen Schaltbefehl (40) zum Schalten der Spannung (U) an den Ausgang (2) zu einem Startzeitpunkt (T0) über den Befehlseingang (33) entgegenzunehmen und daraufhin den zweiten Steuereingang (22) für eine vorbestimmte erste Zeitdauer (T1) anzusteuern, wobei das zweite Treibermodul (12) mit einer Strombegrenzungsvorrichtung (41) für einen maximalen Strom (I) ausgestaltet ist und die Steuerschaltung (30) weiterhin dazu ausgestaltet ist ausgehend von dem Startzeitpunkt (T0) nach Ablauf einer vorbestimmten zweiten Zeitdauer (T2) den ersten Steuereingang (21) solange anzusteuern, wie der Schaltbefehl (40) gültig ist, wobei das erste Treibermodul (11) mit einer Stromabschaltvorrichtung (42) ausgestaltet ist.

8. Ausgabebaugruppe (1) nach Anspruch 7, wobei das zweite Treibermodul (12) ein Drahtbruchprüfmittel (44) aufweist, welches für eine zyklische Drahtbruchprüfung einer zu der Last (L) geführten Leitung (43) ausgestaltet ist.

## Claims

1. Method for operating a digital output subassembly (1) for a programmable logic controller, having an output circuit (10) by which a voltage (U) is connected through to a load (L) connected to an output (2), which results in a current (I), by which a first driver module (11) is operated between a supply voltage connection (3) on the output subassembly (1) and the output (2) and is actuated via a first control input (21) to connect a voltage through to the output (2),
wherein a second driver module (12) is operated in parallel with the first driver module (11) between the supply voltage connection (3) and the output (2) and is also actuated, via a second control input (22), for the purpose of connecting a voltage through to the output (2), **characterised in that** a control circuit (30) receives at a starting time point (T0) a switching command (40) to switch the voltage (U) through to the output (2) and the control circuit (30) thereupon initially actuates the second control input (22) for a predefined first length of time (T1), so that the second driver module (12) is operated with current limitation up to a maximum current (I) and, after a predefined second length of time (T2) has elapsed, measured from the starting time point (T0), the control circuit (30) then actuates in addition the first control input (21) for as long as the switching command (40) remains in force, wherein in the first driver module (11) a current switch-off device is operated such that it is only triggered when a short circuit occurs.

2. Method according to claim 1, wherein the second length of time (T2) is chosen to be less than the first length of time (T1) or equal to the first length of time (T1).

3. Method according to claim 1 or 2, wherein the first driver module (11) is operated with a current switch-off device (42) for the purpose of interrupting the current (I) when a maximum permissible current (I) is reached.

4. Method according to one of claims 1 to 3, wherein a capacitive load is put in circuit as the connected load (L).

5. Method according to one of claims 1 to 4, wherein the output subassembly (1) is operated as a fail-safe automation component designed for functional security.

6. Method according to one of claims 1 to 5, wherein the second driver module (12) is operated with a wire break testing facility (44) and is cyclically activated to test for a wire break in a wire (43) leading to the load (L), wherein the first driver module (11) is switched off during this test time.

7. Digital output subassembly (1) for a programmable logic controller, incorporating an output circuit (10), an output (2), a supply voltage connection (3), a first driver module (11) with a first control input (21), wherein the first driver module (11) is designed for the purpose of connecting a voltage (U) through to the output (2) and is arranged between the supply voltage connection (3) and the output (2),
wherein a second driver module (12) with a second control input (21) is arranged in parallel with the first driver module (11) between the supply voltage connection (3) and the output (2) and is also designed for the purpose of connecting a voltage through to the output (2), **characterised in that** a control circuit (30) has a command input (33), a first command output (31) and a second command output (32) and is designed to accept at a starting time point (T0) via the command input (33) a switching command (40) for the purpose of connecting the voltage (U) through to the output (2) and thereupon to actuate the second control input (22) for a predefined first length of time (T1), wherein the second driver module (12) is designed with a current limitation device (41) for a maximum current (I) and the control circuit (30) is designed in addition so that after a predefined second length of time (T2) has elapsed, measured from the starting time point (T0), it actuates the first control input (21) for as long as the switching command (40) remains in force, wherein the first driver module (11) is equipped with a current switch-off device (42).

8. Output subassembly (1) according to claim 7, wherein the second driver module (12) has a wire break testing facility (44) which is designed for cyclic testing for a wire break in the wire (43) leading to the load (L).

## Revendications

1. Procédé pour faire fonctionner un composant (1) numérique de sortie pour un automate programmable ayant un circuit (10) de sortie, par lequel une tension (U) est appliquée à une charge (L) raccordée à une sortie (2), tension qui a pour conséquence un courant (1), dans lequel, entre une borne (3) de tension d'alimentation du composant (1) de sortie et la sortie (2), on fait fonctionner un premier module (11) d'attaque, que, pour appliquer la tension à la sortie (2), on commande par une première entrée (21) de commande,
dans lequel, entre la borne (3) de la tension d'alimentation et la sortie (2), on fait fonctionner un deuxième module (2) d'attaque en parallèle au premier module (11) d'attaque et on le commande également pour appliquer la tension à la sortie (2) par une deuxième entrée (22) de commande,
**caractérisé en ce qu'**un circuit (30) de commande reçoit une instruction (40) de mise sous tension pour appliquer la tension (U) à la sortie (2) à un instant (T0) de début et le circuit (30) de commande commande ensuite d'abord la deuxième entrée (22) de commande pendant une durée (T1) déterminée à l'avance, on fait fonctionner ensuite le deuxième module (12) d'attaque avec une limitation de courant pour un courant (1) maximum et, à partir de l'instant (T0) de début, après qu'une deuxième durée (T2) déterminée à l'avance s'est écoulée, le circuit (30) de commande commande supplémentairement la première entrée (21) de commande, tant que l'instruction (40) de mise sous tension est valable, dans lequel, dans le premier module d'attaque, on fait fonctionner un dispositif d'interruption du courant, de manière à ce que celui-ci ne se déclenche que s'il apparaît un court-circuit.

2. Procédé suivant la revendication 1, dans lequel on choisit la deuxième durée (T2) plus petite que la première durée (T1) ou égale à la première durée (T1).

3. Procédé suivant la revendication 1 ou 2, dans lequel on fait fonctionner le premier module (11) d'attaque avec un dispositif (42) d'interruption du courant pour interrompre le courant (1), lorsqu'un courant (1) admissible au maximum est atteint.

4. Procédé suivant l'une des revendications 1 à 3, dans lequel on monte une charge capacitive comme charge (L) raccordée.

5. Procédé suivant l'une des revendications 1 à 4, dans lequel on fait fonctionner le composant (1) de sortie comme composant d'automatisation conçu comme sécurisé à un défaut en sécurité fonctionnelle.

6. Procédé suivant l'une des revendications 1 à 5, dans lequel on fait fonctionner le deuxième composant (1) d'attaque avec un moyen (44) de contrôle de rupture de fil et on l'active cycliquement, pour un contrôle de rupture de fil d'une ligne (43) menant à la charge (L), le premier module (11) d'attaque étant mis hors-circuit pendant ce temps de contrôle.

7. Composant (1) de sortie numérique pour un automate programmable comprenant un circuit (10) de sortie, une sortie (2), une borne (3) de tension d'alimentation, un premier module (11) d'attaque ayant une première entrée (21) de commande, le premier module (11) d'attaque étant conformé pour appliquer une tension (U) à la sortie (2) et étant monté entre la borne (3) de tension d'alimentation et la sortie (2),
entre la borne (3) d'alimentation et la sortie (2), est monté, en parallèle au premier module (11) d'attaque, un deuxième module (12) d'attaque qui a une deuxième entrée (21) de commande et qui est conformé également pour appliquer une tension à la sortie (2),
**caractérisé en ce que**
un circuit (30) de commande a une entrée (33) d'instruction, une première sortie (31) d'instruction et une deuxième sortie (32) d'instruction et est conformé pour recevoir, par l'entrée (33) d'instruction, une instruction (40) d'application de la tension (U) à la sortie (2) à un instant (T0) de début et ensuite, pour commander la deuxième entrée (22) de commande pendant une première durée (T1) déterminée à l'avance, le deuxième module (12) d'attaque étant conformé en ayant un dispositif (41) de limitation du courant pour un courant (I) maximum et le circuit (30) de commande étant conformé, en outre, pour commander, à partir de l'instant (T0) de début, après qu'une deuxième durée s'est écoulée, la première entrée (21) de commande, tant que l'instruction (40) de mise sous tension est valable, le premier module (11) d'attaque étant conformé en ayant un dispositif (42) d'interruption du courant.

8. Composant (1) de sortie suivant la revendication 7, dans lequel le deuxième module (12) d'attaque a un moyen (44) de contrôle de rupture de fil conformé pour un contrôle cyclique de rupture de fil d'une ligne (43) menant à la charge (L).
